(19) Europäisches Patentamt
European Patent Office
Office européen des brevets

(11) EP 4 442 644 A1

(12) EUROPEAN PATENT APPLICATION
published in accordance with Art. 153(4) EPC

(43) Date of publication:
09.10.2024 Bulletin 2024/41

(51) International Patent Classification (IPC):
C01G 25/00 (2006.01)     B82Y 20/00 (2011.01)
B82Y 40/00 (2011.01)

(21) Application number: 22901351.1

(22) Date of filing: 30.11.2022

(52) Cooperative Patent Classification (CPC):
B82Y 20/00; B82Y 40/00; C01G 25/00

(86) International application number:
PCT/JP2022/044107

(87) International publication number:
WO 2023/100919 (08.06.2023 Gazette 2023/23)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(30) Priority: 30.11.2021   JP 2021195007
11.03.2022   JP 2022038677

(71) Applicant: Idemitsu Kosan Co.,Ltd.
Tokyo 100-8321 (JP)

(72) Inventors:
• KIMOTO, Yoshinori
  Tokyo 100-8321 (JP)
• INATOME, Toru
  Tokyo 100-8321 (JP)
• KATO, Takuya
  Tokyo 100-8321 (JP)

(74) Representative: Hoffmann Eitle
Patent- und Rechtsanwälte PartmbB
Arabellastraße 30
81925 München (DE)

(54) CHALCOGENIDE PEROVSKITE AND CHALCOGENIDE PEROVSKITE PRODUCTION METHOD USING LIQUID PHASE SYNTHESIS

(57) A chalcogenide perovskite, having a crystallite size $\tau 1$ of less than 40 nm, calculated by Scherrer equation based on the diffraction peak having the largest peak height in the X-ray diffraction spectrum obtained by X-ray diffraction measurement, and a proportion of a total area occupied by particles having a particle diameter of 10 $\mu$m or more measured by microscopy to a total area occupied by particles existing in a captured image range in an image range captured by a microscope of 10% or less.

Figure 2

EP 4 442 644 A1

**Description**

Technical Field

The present invention relates to a chalcogenide perovskite and a method for producing the same, a composition, a powder, a sintered body, a thin film and a method for producing the same, a method for producing a sheet, an emitting material, an emitting device, an image sensor, a photoelectric converting element, and a bioluminescent label.

Background Art

In recent years, quantum dots (semiconductor nanocrystal particles) have exhibited physical properties that differ from those of bulk materials in light absorption properties and light emission properties, such as a change in light absorption wavelength (bandgap energy) according to particle size, and have attracted attention as a next-generation emitting device material.

As quantum dots, a material containing cadmium such as CdS, CdSe, and CdTe has been known, but due to environmental issues, a material containing no harmful metals such as cadmium has been developed.

A chalcogenide perovskite having a perovskite-type crystal structure has been studied as a material containing no harmful metals (see, for example, Non-Patent Documents 1 to 2 and Patent Document 1). For example, Non-Patent Documents 1 to 2 disclose chalcogenide perovskites synthesized by a solid-phase synthesis method.

Synthesis of fine particles by a solid phase synthesis method is a widely known method, but there are problems such as that impurities are easily mixed in the synthesis process and that aggregation of particles is remarkable. For this reason, the particle size distribution of the particles obtained by the solid-phase synthesis method tends to be widened because it is difficult to miniaturize the particle size and control the particle size and shape.

In addition, in the solid phase synthesis method, generally, micron-sized particles are easily obtained, and when the particles are further finely pulverized to form nanoparticles, a large number of defects are generated on the surface and the inside of the particles, so that the fluorescence intensity is remarkably lowered.

On the other hand, the liquid phase synthesis method has attracted attention as a method capable of solving the above-described problem of the solid phase synthesis method in the synthesis of fine particles.

As an example using a liquid phase synthesis method, for example, Patent Document 1 discloses a method for producing semiconductor nanocrystal particles in which a first metal precursor, a second metal precursor, and a chalcogen precursor are heated at a temperature of about 100°C to 400°C in the presence of an organic solvent and a ligand compound.

Related Art Documents

Patent Documents

[Patent Document 1]
US 2019/0225883 A1

Non-Patent Document

[Non-Patent Document 1]
V. K. Ravi et al., "Colloidal BaZrS3 chalcogenide perovskite nanocrystals for thin film device fabrication", The Royal Society of Chemistry, Nanoscale, 2021, Vol.13, p.1616-1623
[Non-Patent Document 2]
S. Filippone et al., "High densification of BaZrS3 powder inspired by the cold-sintering process", Journal of Materials Research, 2021, Vol. 36, p.4404-4412

Summary of the Invention

The present inventors prepared chalcogenide perovskite based on the liquid-phase synthesis method of chalcogenide perovskite disclosed in Patent Document 1. When the crystal structure was examined, it differed from the crystal structure obtained by the solid phase synthesis based on the JCPDS card.

An object of the present invention is to provide a chalcogenide perovskite which is easy to obtain desired light absorption characteristics or light emission characteristics.

Another object of the present invention is to provide a method for producing chalcogenide perovskite having a crystal structure similar to that of solid phase synthesis by liquid phase synthesis.

According to the present invention, the following a chalcogenide perovskite and a method for producing the same and the like are provided.

1. A chalcogenide perovskite, having

a crystallite size $\tau 1$ of less than 40 nm, calculated by Scherrer equation based on the diffraction peak having the largest peak height in the X-ray diffraction spectrum obtained by X-ray diffraction measurement, and
a proportion of a total area occupied by particles having a particle diameter of 10 $\mu$m or more measured by microscopy to a total area occupied by particles existing in a captured image range in an image range captured by a microscope of 10% or less.

2. The chalcogenide perovskite according to 1, wherein a crystallite size $\tau 2$ calculated by Williamson-Hall equation based on an X-ray diffraction spectrum obtained by X-ray diffraction measurement is 34.5 nm or less.

3. The chalcogenide perovskite according to 2, wherein the crystallite size $\tau 2$ is 30 nm or less.

4. The chalcogenide perovskite according to any one of 1 to 3, wherein the crystallite size r1 is less than 17.5 nm.

5. The chalcogenide perovskite according to any one of 1 to 4, wherein the chalcogenide perovskite has a composition represented by the following formula (101) or (102):

$$ABCh_3 \cdots \qquad (101)$$

$$A'_2A_{n-1}B_nCh_{3n+1} \cdots \qquad (102)$$

wherein in the formula (101), (102), A and A' are independently Sr, Ba or a combination thereof, B is Zr, Hf or a combination thereof, and Ch is S, Se, Te or a combination thereof; in the formula (102), n is an integer of 1 to 10; in the formula (102), A and A' may be the same as or different from each other; and the chalcogenide perovskite may be a solid solution obtained by substituting a part or all of A, A', B, and Ch with another element in the composition represented by the formula (101) or (102).

6. The chalcogenide perovskite according to any one of 1 to 5, wherein the particles of chalcogenide perovskite are surface-modified by a ligand.

7. A composition, wherein the chalcogenide perovskite according to any one of 1 to 6 is dispersed in a dispersion medium.

8. The composition according to 7, which is a dispersion liquid using a liquid dispersion medium as the dispersion medium.

9. The composition according to 8, wherein the liquid dispersion medium is at least one selected from the group consisting of water, ester, ketone, ether, alcohol, glycol ether, organic solvent having an amide group, organic solvent having a nitrile group, organic solvent having a carbonate group, organic solvent having a halogenate hydrocarbon group, organic solvent having a hydrocarbon group, and dimethyl sulfoxide.

10. The composition according to 7, which is a sheet using a solid-state dispersion medium as the dispersion medium.

11. The composition according to 10, wherein the solid-state liquid dispersion medium is at least one selected from the group consisting of polyvinyl butyral, polyvinyl acetate, and silicone and derivative thereof.

12. A powder comprising the chalcogenide perovskite according to any one of 1 to 6.

13. The powder according to 12, wherein primary particles or secondary particles of the chalcogenide perovskite are surface-modified with a ligand.

14. A sintered body obtained by sintering the powder according to 12 or 13.

15. A thin film comprising the chalcogenide perovskite according to any one of 1 to 6.

16. A method for producing the thin film according to 15, wherein the dispersion liquid according to 8 or 9 is deposited by an application method, a spraying method, a doctor blade method, or an ink-jet method.

17. A method for producing the thin film according to 15, wherein the chalcogenide perovskite powder according to 12 or 13 is deposited by a sputtering method or a vacuum deposition method.

18. A method for producing the sheet according to 10, wherein the dispersion liquid according to 8 or 9 is applied in a sheet form and then dried.

19. An emitting material comprising the chalcogenide perovskite according to any one of 1 to 6.

20. An emitting device, an image sensor, a photoelectric converter, or a bioluminescent label, comprising the chalcogenide perovskite according to any one of 1 to 6.

21. A method for producing a chalcogenide perovskite, wherein a complex having a first metal atom and a complex having a second metal atom are reacted in a liquid phase, wherein the complex having a first metal atom and the complex having a second metal atom has a ligand free of oxygen atom (O) and halogen atom (X) as coordination atoms.

22. The method for producing according to 21, wherein the complex having a first metal atom and the complex having a second metal atom independently have a ligand coordinating with atom selected from the group consisting of nitrogen atom (N), sulfur atom (S), selenium atom (Se), tellurium atom (Te), carbon atom (C), and phosphorus atom (P).

23. The method for producing according to 21 or 22, wherein the metal atom of the complex having a first metal atom is at least one of Sr and Ba, and the metal atom of the complex having a second metal atom is at least one of Zr and Hf.

24. The method for producing according to 23, wherein at least one selected from Ti, Ca, and Mg is further used for at least one of the metal atom of the complex having a first metal atom and the metal atom of the complex having a second metal atom.

25. The method for producing according to any one of 21 to 24, wherein the ligand is a dithiocarbamate, a xanthate, a trithiocarbamate, a dithioester, a thiolate, a sulfide, a compound substituted a part or all of sulfur atom contained therein with a selenium atom or a tellurium atom, an alkylamine, an arylamine, a trialkylsilylamine, a nitrogen-containing aromatic ring, an alkane, an unsaturated hydrocarbon ring, a group derived from the unsaturated hydrocarbon ring, a cyan, a trialkylphosphine, a triarylphosphine, or a diphosphine.

26. The method for producing according to any one of 21 to 25, wherein the complex having a first metal atom and the complex having a second metal atom is a binuclear complex of a single compound.

27. The method for producing according to 26, wherein the first metal atom and the second metal atom are bonded via a ligand coordinating with sulfur atom, selenium atom, or tellurium atom.

28. The method for producing according to any one of 21 to 27, wherein the chalcogenide perovskite has a composition represented by the following formula (101) or (102):

$$ABCh_3 \cdots \qquad (101)$$

$$A'_2A_{n-1}B_nCh_{3n+1} \cdots \qquad (102)$$

wherein in the formula (101), (102), A and A' are independently Sr, Ba or a combination thereof, B is Zr, Hf or a combination thereof, and Ch is S, Se, Te or a combination thereof; in the formula (102), n is an integer of 1 to 10; in the formula (102), A and A' may be the same as or different from each other; the chalcogenide perovskite may be a solid solution obtained by substituting a part or all of A, A', B, and Ch with another element in the composition represented by the formula (101) or (102).

29. The method for producing according to any one of 21 to 28, wherein a chalcogen compound is further added.

30. The method for producing according to any one of 21 to 29, wherein an amine-based compound is further added.

31. The method for producing according to any one of 21 to 30, wherein the temperature of the liquid phase is set at room temperature to 450°C.

32. The method for producing according to 31, wherein the temperature of the liquid phase is set at 120°C to 360°C.

33. The method for producing according to any one of 21 to 32, wherein the reaction is caused by adding a second raw material to a first raw material, and the first raw material comprises at least a solvent among raw material components including the complex having a first metal atom, the complex having a second metal atom, and a solvent, and the second raw material comprises at least a raw material component not comprised in the first raw material among the raw material components.

34. The method for producing according to 33, wherein the reaction is caused by adding the second raw material to the first raw material in a state in which at least one of the first raw material and the second raw material is preheated.

35. The method for producing according to 33, wherein the reaction is caused by heating the first raw material and the second raw material after adding the second raw material to the first raw material.

36. The method for producing according to 35, wherein a dispersion liquid in which the complex having a first metal atom and the complex having a second metal atom are dispersed in a dispersion medium is deposited by an application method, spraying method, doctor blade method, or ink-jet method, and the obtained coating film is heat-treated.

37. The method for producing according to any one of 21 to 32, wherein the reaction is caused by simultaneously mixing the complex having a first metal atom, the complex having a second metal atom, and at least one of the chalcogen compound and the amine-based compound.

38. The method for producing according to 37, wherein the reaction is caused by circulating the complex having a first metal atom, the complex having a second metal atom, and at least one of the chalcogen compound and the amine-based compound as independent flows, and simultaneously merging the flows.

39. The method for producing according to 37 or 38, wherein at least one of the complex having a first metal atom, the complex having a second metal atom, and at least one of the chalcogen compound and the amine-based compound is preheated.

According to the present invention, it is possible to provide chalcogenide perovskite that can easily obtain desired light absorption characteristics or light emission characteristics. Further, according to the present invention, it is possible to provide a production method in which chalcogenide perovskite having a crystal structure similar to that of solid phase synthesis is obtained by liquid phase synthesis.

Brief Description of the Drawings

Figure 1 is a diagram for explaining the relationship between the crystallite size d10 and the particle size d20.
Figure 2 is an X-ray diffraction spectrum of chalcogenide perovskite prepared in Example 1 and Example 2.
Figure 3A is a diagram showing an approximate straight line created by Williamson-Hall equation based on the diffraction peaks of the X-ray diffraction spectrum of Example 1.
Figure 3B is a diagram showing an approximate straight line created by Williamson-Hall equation based on the diffraction peaks of the X-ray diffraction spectrum of Example 2.
Figure 4 is a SEM image (250000x) of the composite obtained in Example 1.
Figure 5 is a SEM image (250000x) of the composite obtained in Example 1.
Figure 6 is a STEM image (200000x) of the composite obtained in Example 2.
Figure 7 is a STEM image (400000x) of the composite obtained in Example 2.

Mode for Carrying out the Invention

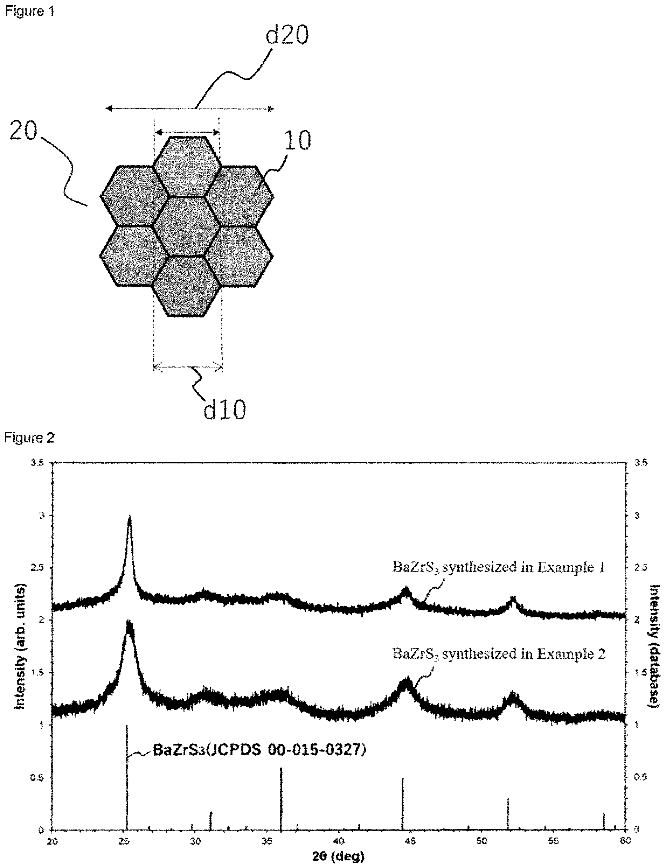

Hereinafter, a mode for carrying out the invention will be described.
In the present specification, "x to y" represents a numerical value range of "x or more and y or less". An upper limit value and a lower limit value described for the numerical range may be arbitrarily combined.
In addition, two or more embodiments that are not contrary to each other out of the individual embodiments of an aspect according to the present invention to be described below may be combined, and an embodiment in which the two or more embodiments are combined is also an embodiment of the aspect according to the present invention.
In the chalcogenide perovskite according to one aspect of the present invention, a crystallite size $\tau1$ calculated by Scherrer equation (Scherror's equation) is less than 40 nm. In addition, in the image range captured by the microscope, the proportion of the total area occupied by the particles having a particle diameter of 10 $\mu$m or more measured by the microscopy to the total area occupied by the particles present in the captured image range is characterized by 10% or less.
In the following explanation, the "crystallite size" refers to the diameter d10 of the crystallite 10 calculated by Scherrer equation or Williamson-Hall equation (Williamson-Hall's equation) described below, and the diameter d20 of the polycrystal 20 formed by assembling a plurality of crystallites 10 is referred to as a "particle size" (see Figure 1).

[Crystallite Size $\tau1$]

The crystallite size $\tau1$ is calculated by a Scherrer equation represented by the following formula (a) based on the diffraction peak having the largest peak height in the X-ray diffraction spectrum obtained by X-ray diffraction measurement.

$$\tau1 = K\lambda/\beta\cos\theta \ ...(a)$$

$\theta$: Diffraction angle of Maximum peak [rad]
$\beta$: Half width of Maximum peak [rad]
K: Shape factor
$\lambda$: X-ray wavelength
r1: crystallite size

X-ray diffraction measurements are performed according to the methods described in the Examples.
Some chalcogenide perovskites have an absorption spectrum and an emission spectrum overlapping with each other in some wavelength regions, for example, as in $BaZrS_3$ described later. In the wavelength region where the absorption spectrum and the emission spectrum overlap each other, a part of the emission emitted from the particle is reabsorbed by the particles in the vicinity thereof (self-reabsorption), and thus luminous efficiency decreases.

In the chalcogenide perovskite of the present aspect, since the crystallite size $\tau 1$ is less than 40 nm, the size of the particles is sufficiently small, so that self-reabsorption can be suppressed. Therefore, by applying the chalcogenide perovskite of the present aspect to the emitting material, excellent luminous efficiency can be exhibited and excellent emitting properties can be obtained.

When the particle size is reduced to the nanometer order, the excited carriers (electrons and holes) are spatially confined, and the carriers are less likely to be dispersed (carrier confinement effect).

In the chalcogenide perovskite of the present aspect, the crystallite size $\tau 1$ is less than 40 nm, and the mobility of excited and confined carriers is narrowed, so that the probability of recombination within the particle is improved. Therefore, by applying the chalcogenide perovskite of the present aspect to the emitting material, luminous efficiency can be improved and excellent emitting properties can be obtained.

Further, by coating (core-shelling) the chalcogenide perovskite of the present aspect with a material having a larger bandgap than that of the chalcogenide perovskite, the carrier confinement effectiveness can be enhanced.

In general, when the particle diameter decreases to the nanometer order, the band structure (energy level) of the particle becomes discrete, and the value of the optical band gap changes depending on the particle size (quantum size effect). In this case, the value of the bandgap gradually increases as the particle diameter decreases, and the value of the bandgap abruptly increases when it becomes smaller than a predetermined particle diameter.

The chalcogenide perovskite of this aspect may exhibit a higher bandgap as compared to those of larger grain sizes due to the crystallite size $\tau 1$ being less than 40 nm. In particular, when the crystallite size $\tau 1$ is 30 nm or less, this effect is increased. For this reason, the band gap can be changed to a desired value by changing the crystallite size $\tau 1$ of the particles in a range of less than 40 nm.

By controlling the band gap of the chalcogenide perovskite of the present aspect to an appropriate range and applying it to, for example, a photovoltaic cell or an emitting material, the chalcogenide perovskite can be controlled so as to exhibit light-absorbing properties and emitting properties (emitting wavelengths) suitable for each use form.

The crystal size $\tau 1$ of chalcogenide perovskite may be 35 nm or less, 30 nm or less, 25 nm or less, 20 nm or less, less than 17.5 nm, 17 nm or less, 15 nm or less, 13 nm or less, 12 nm or less, 11.5 nm or less, or 10 nm or less.

The lower limit of the crystallite size $\tau 1$ of the chalcogenide perovskite is not particularly limited, but may be, for example, 1 nm or more from the viewpoint of convenience in the production process.

In one embodiment, the chalcogenide perovskite has the largest diffraction peak at $2\theta = 25.0 \pm 1$ deg in the X-ray diffraction spectrum obtained by the aforementioned X-ray diffraction measurement. The crystallite size $\tau 1$ calculated based on the diffracted peak ($2\theta = 25.0 \pm 1$ deg) is less than 40 nm.

The crystallite size $\tau 1$ calculated on the basis of the diffraction peak of $2\theta = 25.0 \pm 1$ deg may be 35 nm or less, 30 nm or less, 25 nm or less, 20 nm or less, less than 17.5 nm, 17 nm or less, 15 nm or less, 13 nm or less, 12 nm or less, 11.5 nm or less, or 10 nm or less, and may be 1 nm or more.

In the chalcogenide perovskite of the present aspect, the proportion of the total area occupied by the particles having a particle diameter of 10 $\mu$m or more measured by microscopy to the total area occupied by the particles present in the captured image range in the image range photographed by the microscope is 10% or less, whereby the uniformity of the film or the sheet formed by using the chalcogenide perovskite of the present aspect is improved.

Further, in the image range captured by the microscope, the proportion of the total area occupied by the particles having a particle diameter of 10 $\mu$m or more measured by the microscopy to the total area occupied by the particles present in the captured image range is 10% or less, so that it is possible to suppress nozzle clogging when applying the ink produced by using the chalcogenide perovskite of the present aspect.

In addition, in the image range captured by the microscope, the proportion of the total area occupied by the particles having a particle diameter of 10 $\mu$m or more measured by the microscopy to the total area occupied by the particles present in the captured image range is 10% or less, so that the emission spectrum distribution as a quantum dot is narrowed. Therefore, by applying the chalcogenide perovskite of the present aspect to the emitting material, color unevenness of light emission is suppressed, color purity is increased, and monochromaticity is improved.

Microscopy is a method measured by the direct measurement of the size and number of particles on light or electron microscopic images. Though there are Ferray diameter, Haywood diameter, Martin diameter, Krumvin diameter, etc. as the diameter which is an index in evaluating the particle diameter, the diameter which is evaluated by the Haywood diameter as an index is adopted as the particle diameter, from the viewpoint of the easiness of calculation by image analysis.

When the particle size is measured by microscopy, the particle size may differ depending on the measurement point. In consideration of this point, when the particle diameter is measured by microscopy, image capturing is performed at a plurality of locations, and the particle diameter is measured for each of the plurality of captured images obtained by the image capturing. Further, when the particle diameter is measured by microscopy, image capturing is performed at a plurality of locations, and the proportion of the total area occupied by the particles having a particle diameter of 10 $\mu$m or more is calculated for each of the plurality of captured images. In addition, when the particle size distribution is measured by microscopy, the imaging range is a range in which 100 or more particles are included.

The calculation method of "the proportion of the total area occupied by the particles having a particle diameter of 10 $\mu$m or more measured by microscopy to the total area occupied by the particles present in the captured image range" will be described in detail in Examples.

In one embodiment, the crystallite size $\tau2$ calculated by Williamson-Hall equation represented by the following formula (b) based on the X-ray diffraction spectrum obtained by X-ray diffraction measurement is 34.5 nm or less

$$\beta\cos\theta=\varepsilon(2\sin\theta)+K\lambda/\tau2 \;...(b)$$

$\theta$: Diffraction angle of diffraction peak [rad]
$\beta$: Half width of diffracted peak [rad]
K: Shape factor
$\lambda$: X-ray wavelength
$\varepsilon$: lattice strain
$\tau2$: crystallite size

X-ray diffraction measurements are performed according to the methods described in the Examples.

In the above formula (b), it is assumed that the half width $\beta$ of the diffracted peak corresponds to the sum of the half width ($\beta_{size}$) caused by the crystallite size and the half width ($\beta_{strain}$) caused by the lattice strain.

Calculation of the crystallite size $\tau2$ according to the formula (b) is performed according to the procedures described in the Examples.

The effect of the crystallite size $\tau2$ being 34.5 nm or less is similar to the effect of the crystallite size $\tau1$ being less than 40 nm.

Crystal size $\tau2$ of chalcogenide perovskite may be 32 nm or less, 30 nm or less, 25 nm or less, 20 nm or less, 18 nm or less, 15 nm or less, 14.5 nm or less, or 10 nm or less.

The lower limit of the crystallite size $\tau2$ of the chalcogenide perovskite is not particularly limited, but may be, for example, 1 nm or more from the viewpoint of convenience in the production process.

The chalcogenide perovskite according to one embodiment is a compound containing chalcogen (a group 16 element other than oxygen (S, Se, or Te)) having a perovskite-type crystal structure, and contains, in addition to chalcogen, two or more kinds of metal elements such as a transition metal element and an alkaline earth metal element as constituent components of the perovskite-type crystal structure.

In one embodiment, the chalcogenide perovskite has a composition represented by, for example, the following formula (101) or (102).

$$ABCh_3\cdots \qquad (101)$$

$$A'_2A_{n-1}B_nCh_{3n+1}\cdots \qquad (102)$$

In the formula (101), (102), A, A' are independently Sr, Ba or a combination of any ratios thereof, B is Zr, Hf, or a combination of any ratios thereof, and Ch is S, Se, Te, or a combination of any ratios thereof.

In the formula (102), n is an integer of 1 to 10.

In the formula (102), A and A' may be the same or different from each other.

In one embodiment, the chalcogenide perovskite may be a solid solution in which a part or all of A, A', B, and Ch are substituted with another element in the composition represented by the formula (101) or (102).

The chalcogenide perovskite ($ABCh_3$) represented by the formula (101) represents, for example, the crystal structure of a cubic perovskite, a tetragonal perovskite, an orthorhombic perovskite, or a double perovskite.

The chalcogenide perovskite ($A'_2A_{n-1}B_nCh_{3n+1}$) represented by the formula (102) represents, for example, the crystal structure of a Ruddlesden-Popper type layered perovskite.

In one embodiment, particles of the chalcogenide perovskite are surface-modified with a ligand.

The particles of the chalcogenide perovskite of the present embodiment surface-modified by a ligand can be easily dispersed in a liquid dispersion medium and a solid-state dispersion medium such as a polymer compound.

There is no limitation on the type of ligand for surface-modifying the chalcogenide perovskite, and it is sufficient that the ligand is generally used for dispersing the nanoparticles. Examples of the surface-modifying ligand include one or more selected from the group consisting of oleylamine, oleic acid, dodecanethiol, and trioctylphosphine.

The dispersion medium for dispersing the chalcogenide perovskite of the present embodiment surface-modified by the ligand may be a liquid or a solid-state dispersion medium.

The liquid dispersion medium (referred to as a liquid dispersion medium in the following description) may be, for example, various solvents selected from the group consisting of a non-aqueous solvent such as toluene and hexane, and water, or a dispersion liquid in which other components other than chalcogenide perovskite are dispersed in these solvents.

The solid dispersion medium (hereinafter referred to as a solid dispersion medium) may be, for example, a polymer compound such as polyethylene.

For example, in order to disperse the chalcogenide perovskite particles synthesized by the solid phase synthesis method in the above-described dispersion medium, it is preferable to enhance dispersibility in various dispersion media by performing surface modification in which the surface of the particles is modified with a ligand.

On the other hand, when particles of chalcogenide perovskite are synthesized by a liquid phase synthesis method, the chalcogenide perovskite can be obtained as the particles surface-modified with the ligand by performing the synthesis reaction in a state in which the ligand is present in advance in the liquid phase that becomes the reaction liquid of the liquid phase synthesis.

(Composition)

In the composition according to one embodiment, the chalcogenide perovskite according to the present embodiment is dispersed in a dispersing medium.

In the composition according to one embodiment, the chalcogenide perovskite according to the present aspect described above, which is surface-modified by a ligand, is dispersed in a dispersion medium.

As described above, the chalcogenide perovskite surface-modified by a ligand can be easily dispersed in a liquid dispersion medium and a solid-state dispersion medium such as a polymer compound. Therefore, in the composition according to the present embodiment, the chalcogenide perovskite is uniformly dispersed in the dispersion medium, and has good properties as the composition.

In the composition according to one embodiment, it is a dispersion liquid using a liquid dispersion medium as a dispersion medium.

In the present specification, a dispersion liquid of chalcogenide perovskite refers to a liquid dispersion medium in which the chalcogenide perovskite is dispersed.

"The chalcogenide perovskite is dispersed" refers to a state in which the chalcogenide perovskite is floated or suspended in a liquid dispersion medium, and a part of the chalcogenide perovskite may be precipitated in the dispersion.

The dispersion liquid of chalcogenide perovskite may contain, as an additive, an acid, a base, a binder material, or the like in addition to chalcogenide perovskite, for the purpose of improving various properties such as dispersibility, luminescence properties, and film formability of chalcogenide perovskite.

The size of the primary particles and the secondary particles of the chalcogenide perovskite dispersed in the dispersion liquid is not particularly limited. The size of the primary particles in the dispersion liquid is preferably, for example, from 5 to 1000 nm, more preferably from 5 to 100 nm, and still more preferably from 5 to 20 nm.

The kind of liquid dispersion medium used in the dispersion liquid of chalcogenide perovskite is not particularly limited, and examples thereof include water, esters such as methyl formate, ethyl formate, propyl formate, pentyl formate, methyl acetate, ethyl acetate, pentyl acetate, and the like; ketones such as γ-butyrolactone, acetone, dimethyl ketone, diisobutyl ketone, cyclopentanone, cyclohexanone, methylcyclohexanone, and the like; ethers such as diethyl ether, methyl-tert-butyl ether, diisopropyl ether, dimethoxymethane, dimethoxyethane, 1,4-dioxane, 1,3-dioxolane, 4-methyldioxolane, tetrahydrofuran, methyltetrahydrofuran, anisole, phenetol, and the like; alcohols such as methanol, ethanol, 1-propanol, 2-propanol, 1-butanol, 2-butanol, tert-butanol, 1-pentanol, 2-methyl-2-butanol, methoxypropanol, diacetone alcohol, cyclohexanol, 2-fluoroethanol, 2,2,2-trifluoroethanol, 2,2,3,3-tetrafluoro-1-propanol, and the like; glycol ethers such as ethylene glycol monomethyl ether, ethylene glycol monoethyl ether, ethylene glycol monobutyl ether, ethylene glycol monoethyl ether acetate, triethylene glycol dimethyl ether, and the like; organic solvents having an amide group such as N-methyl-2-pyrrolidone, N,N-dimethylformamide, acetamide, N,N-dimethylacetamide, and the like; organic solvents having a nitrile group such as acetonitrile, isobutyronitrile, propionitrile, methoxyacetonitrile, and the like; organic solvents having a carbonate group such as ethylene carbonate, propylene carbonate, and the like; organic solvents having a halogenated hydrocarbon group such as methylene chloride, chloroform, and the like; organic solvents having a hydrocarbon group such as n-pentane, cyclohexane, n-hexane, benzene, toluene, xylene, and the like; dimethyl sulfoxide, and the like.

As the liquid dispersion medium used in the dispersion liquid of chalcogenide perovskite, one kind of liquid dispersion may be used alone, or two or more kinds of liquid dispersion may be used in combination.

A use for dispersion liquid of chalcogenide perovskite is not particularly limited.

For example, it may be used as a film forming material for forming a film by a solution film forming method such as application process, spraying method, or doctor blade method, or may be used as a composite composition in which a dispersion liquid of chalcogenide perovskite and a solid-state dispersion medium are combined.

The film and the composition prepared using a dispersion liquid of chalcogenide perovskite are used, for example, in the production of various devices described below.

A method for producing the chalcogenide perovskite according to one aspect of the present invention described above will be described below.

A method for producing a chalcogenide perovskite according to one aspect of the invention is characterized in that a complex having a first metal atom and a complex having a second metal atom, having a ligand which does not contain oxygen atom (O) and halogen atom (X) as a coordination atom are reacted in a liquid phase.

The present inventors have found that when chalcogenide perovskite is synthesized in a liquid phase, for example, a component containing halogen atom (X) such as a halide compound or a component containing oxygen atom (O) such as an acetate salt mixed in the liquid phase synthesis may inhibit the reaction, which affects the purity and crystalline structure of chalcogenide perovskite as an object.

Examples of halogen atom (X) include fluorine atom (F), chlorine atom (Cl), bromine atom (Br), and iodine atom (I).

In this aspect, the liquid-phase synthetic reaction can be performed without for example a component containing oxygen atom such as metal acetate and a component containing halogen atom such as a metal halide to be present in the liquid phase, by reacting the complex having the first metal atom and the complex having the second metal atom, having a ligand free of oxygen atom and halogen atom as coordination atoms. Accordingly, it is possible to suppress the reaction of the constituent elements of the chalcogenide perovskite with oxygen atom and halogen atom in the liquid phase. As a result, a crystal structure similar to the solid phase synthesis can be developed.

Hereinafter, a method for producing the complex having a first metal atom, the complex having a second metal atom as starting materials, and chalcogenide perovskite will be described.

[Complex having first metal atom and Complex having second metal atom]

In this aspect, the ligand of complex having the first metal atom and complex having the second metal atom are not particularly limited, except that they do not include oxygen atom and halogen atom as the coordination atoms. Examples include ligands coordinated with atom selected from the group consisting of nitrogen atom (N), sulfur atom (S), selenium atom (Se), tellurium atom (Te), carbon atom (C) and phosphorus atom (P).

Examples of the ligand coordinating with nitrogen atom include alkylamines ($NR_2$) such as amine, dimethylamine, diethylamine, and methylethylamine; arylamines (NHAr) such as phenylamine; trialkylsilylamines ($N(SiR_3)_2$) such as silylamine and trimethylsilylamine; nitrogencontent aromatic rings such as pyrazole, and the like.

Examples of the ligand coordinating with sulfur atom include dithiocarbamate ($S_2CNR_2$), xanthate ($S_2COR$), trithiocarbamate ($S_2CSR$), dithioester ($S_2CR$), thiolate (SR) and the like.

Examples of the ligand coordinating with selenium atom or tellurium atom include compound in which a part or all of sulfur atom of the ligand coordinating with sulfur atom is replaced with selenium atom or tellurium atom.

The complex having the first metal atom and the complex having the second metal atom may be a single compound (binuclear complex). A single compound (binuclear complex) refers to a compound having, in one complex, both the first metal atom and the second metal atom as the central metal ion of the complex. Preferably, the first metal atom and the second metal atom may be bonded via a ligand coordinating with sulfur atom, selenium atom, or tellurium atom.

Examples of the binuclear complex in which the ligand is coordinated with sulfur atom include heterobimetal thiolates and heterobimetal sulfides. In these binuclear complexes, the first metal atom and the second metal atom are bonded via thiolates or sulfides (ligands coordinated with sulfur atom) as ligands.

Examples of the binuclear atom in which the ligand is coordinated by selenium atom or tellurium atom include those in which a part or all of sulfur atom in the binuclear complex in which the ligand is coordinated by sulfur atom is replaced by selenium atom or tellurium atom.

Examples of the ligand coordinating with carbon atom include alkanes such as methyl and ethyl; unsaturated hydrocarbon rings such as cyclopentadiene, cyclooctadiene, and indene; and groups derived from benzyl groups and unsaturated hydrocarbon rings described above; and cyan (CN).

Examples of the ligand coordinating with phosphorus atom include trialkylphosphines (PRs) such as trioctylphosphine and tricyclohexylphosphine; triarylphosphines (PArs) such as triphenylphosphine and tri(o-tolyl)phosphine; diphosphines ($R_2P$-$(CH_2)_m$-$PR_2$), and the like.

The ligand may be a derivative of the ligand described above.

In the formula, R is hydrogen atom, a saturated hydrocarbon group or an unsaturated hydrocarbon group including 1 to 20 carbon atoms. When one ligand contains two or more R, R may be the same or different from each other.

Ar is an aryl group having 6 to 20 carbon atoms which may have a substituent, such as a phenyl group, a naphthyl group, or an anthracenyl group. Examples of substituent include alkyl group including 1 to 10 carbon atoms. When one ligand contains two or more Ar, Ar may be the same or different from each other. m is an integer from 1 to 10.

Among the above-mentioned ligands, ligands coordinated with nitrogen atom or ligands coordinated with sulfur atom are preferred.

Further, a ligand having a structure selected from the group consisting of the following formulas (1) to (7) are preferable.

$$S_2CNR^a_2 \qquad (1)$$

$$S_2COR \qquad (2)$$

$$S_2CSR^a \qquad (3)$$

$$S_2CR^a \qquad (4)$$

$$SR^a \qquad (5)$$

$$NR^a_2 \qquad (6)$$

$$N(SiR^a_3)_2 \qquad (7)$$

In the formulas, $R^a$ is a hydrogen atom, a saturated hydrocarbon group including 1 to 20 carbon atoms, or an unsaturated hydrocarbon group including 1 to 20 carbon atoms. When one ligand has a plurality of $R^a$, the plurality of $R^a$ may be the same or may be different.

The above-mentioned saturated hydrocarbons and unsaturated hydrocarbons include alkyl group including 1 to 20 carbon atoms, cycloalkyl group including 3 to 20 carbon atoms, alkenyl group including 2 to 20 carbon atoms, alkynyl group including 2 to 20 carbon atoms, cycloalkenyl group including 3 to 20 carbon atoms, cycloalkynyl group including 3 to 20 carbon atoms, and an aryl group including 6 to 20 carbon atoms.

The saturated hydrocarbon group and the unsaturated hydrocarbon group may have substituent. Examples of the substituent include alkyl group including 1 to 10 carbon atoms.

In one embodiment, the ligand is preferably a compound represented by the above formula (1). $R^a$ of the formula (1) is preferably an alkyl group including 1 to 10 carbon atoms, and more preferably an alkyl group including 2 to 6 carbon atoms.

The ligands used in this aspect can be synthesized according to conventional methods. A commercially available compound may also be used.

The metal atom of complex having the first metal atom is a metal atom selected from alkaline earth metal elements, and the metal atom of complex having the second metal atom is a metal atom selected from transition metal elements.

In one embodiment, the metal atom of complex having the first metal atom is at least one of Sr and Ba, and the metal atom of complex having the second metal atom is at least one of Zr and Hf.

At least one of the metal atoms of complex having the first metal atom and the metal atom of complex having the second metal atom may further contain at least one selected from Ti, Ca, and Mg.

The raw material components can be selected according to the type of the metal atom and the ligand respectively contained in the complex having the first metal atom and the complex having the second metal atom, and can be synthesized by known methods. A commercially available metal complex may also be used.

Hereinafter, as an exemplary process for synthesizing the complex having the first metal atom and the second metal atom, the synthesis of a metal complex $(M(S_2CNR_2)_X)$ having a ligand $(S_2CNR_2)$ represented by the formula (1) will be described.

First, as the metal raw material (M) which is a source of the metal atom of the metal complex, at least one selected from, for example, Ba, Sr, Ca, Mg, Zr, and Hf or a salt thereof is dissolved in a solvent such as water.

The solvent is not particularly limited as long as it is capable of dissolving the metal raw material (M), and may be, for example, an organic solvent.

Then, the solution dissolving the metal raw material is added ammonia or amine compound as a source of nitrogen (N) contained in the complex ligand to be synthesized, and the solution is stirred.

As the amine compound, a primary amine or a secondary amine can be used without any particular limitation, and the type of the substituted hydrocarbon group and the like in these amine compounds are not particularly limited.

Then, a source of sulfur (S) contained in the complex ligand to be synthesized is added to the solution to which the nitrogen (N) source is added, and the solution is stirred.

Sources of sulfur (S) typically include $CS_2$, although other compound can be used depending on the composition of complex ligand to be synthesized. When Se or Te is contained in place of sulfur (S), $CSe_2$, $CTe_2$ can be used.

Then, the solid formed by stirring or the precipitate precipitated in the solution can be isolated by known methods to obtain the desired metal complex.

[Method for producing chalcogenide perovskite]

In this aspect, the chalcogenide perovskite is produced by reacting the complex having the first metal atom and the complex having the second metal atom in solvents.

The solvents can be appropriately selected from the viewpoints of soluble of the complex having the first metal atom and the complex having the second metal atom, and $H_2S$ generation efficiency.

Examples of the solvents include saturated aliphatic hydrocarbons, unsaturated aliphatic hydrocarbons, aromatic hydrocarbons, nitrogen-containing heterocyclic compound, alcohols, aldehydes, carboxylic acids, primary amines, secondary amines, tertiary amines, phosphine compound, thiols, and the like.

As the solvent, it is preferable to use a higher boiling point in consideration of the fact that the liquid phase may be heated to a high temperature of, for example, 300°C or higher in the liquid phase synthesis step described later.

Alkenes including 10 to 30 carbon atoms, such as octadecene, have a high boiling point, and thus can be suitably used as a solvent.

In one embodiment, in addition to the complex having the first metal atom and the complex having the second metal atom, a chalcogen compound can be further added to the liquid phase. For example, when the ligands of both of the complex having the first metal atom and the complex having the second metal atom do not have a chalcogen element such as sulfur (S) or it is insufficient in the chalcogen element of the ligand, the chalcogen compound is added to the liquid phase, so that the composition of target chalcogenide perovskite can be adjusted.

As the chalcogen compound, those which do not contain oxygen atom (O) and halogen atom (X) are preferably used. Examples thereof include sulfur, sulfides such as carbon disulfide ($CS_2$) or hydrogen sulfide ($H_2S$), selenium or selenide, tellurium or telluride, hexane thiol, octanethiol, decanethiol, dodecanethiol (n-dodecanethiol, t-dodecanethiol), hexadecanethiol, mercaptopropylsilane, dialkylthiourea ($S = C(NR_2)_2$), sulfur-trioctylphosphine (trioctylphosphine sulfide; S-TOP), sulfur-tributylphosphine (S-TBP), sulfur-triphenylphosphine (S-TPP), sulfur-trioctylamine (S-TOA), bis (trimethylsilyl) sulfide, ammonium sulfide, sodium sulfide, selenium-trioctylphosphine (Se-TOP), selenium-tributylphosphine (Se-TBP), and selenium-triphenylphosphine.

Among them, a thiourea such as dialkylthiourea ($S=C(NR_2)$) has a boiling point higher than that of carbon disulfide ($CS_2$), and thus can be suitably used as a chalcogen compound.

In one embodiment, in addition to the above-described the complex having the first metal atom and the complex having the second metal atom, an amine-based compound can be further added to the liquid phase. The amine-based compound functions as an initiator. The amine-based compound may be used as the above-described solvents.

As the amine-based compound, those which do not contain oxygen atom (O) and halogen atom (X) are preferably used. Examples thereof include an alkylamine having one alkyl group, such as oleylamine, hexadecylamine, and octadecylamine, a dialkylamine having two alkyl group including 1 to 30 carbon atoms, and a trialkylamine having three alkyl group including 1 to 30 carbon atoms (for example, trioctylamine).

From the viewpoint of sufficiently exhibiting the function as an initiator of the ligand and the metal component, it is preferable that the amine-based compound is added in an amount equal to or greater than the total amount of the number of ligands contained in the complex having the first metal atom and the complex having the second metal atom added in the liquid phase.

In addition, the amine-based compound may be added to the liquid phase in an excessively larger amount than the above-described amount (an equivalent amount with respect to the total amount of the ligand numbers) from the viewpoint of exhibiting a function as a surfactant adhering to the particle surface of the final obtained chalcogenide perovskite.

In the method for producing of the present aspect, the complex having the first metal atom and the complex having the second metal atom described above, and the chalcogen compound and the amine-based compound as needed may be reacted in a liquid phase, and the procedure and the like thereof are not particularly limited. The method for producing of the present aspect can be performed by a known method such as a hot injection method, a heat-up method, or a flow synthesis method.

The blending ratio of the complex having the first metal atom and the complex having the second metal atom can be adjusted according to the composition of the target chalcogenide perovskite.

In the production process according to one embodiment, when a raw material component containing at least the complex having the first metal atom, the complex having the second metal atom, and a solvent is used as a raw material component, a first raw material containing at least the solvent and a second raw material containing at least a rest raw material component not contained in the first raw material among the aforementioned raw material components are prepared. Then, a second raw material is added to the first raw material to cause a reaction.

In the present embodiment, it is preferable that the second raw material is added to the first raw material while at least one of the first raw material and the second raw material is heated in advance.

Alternatively, a second raw material may be added to the first raw material and then heated to cause a reaction.

Hereinafter, the method for producing of the present embodiment will be described by taking a case where the method for producing is performed using a hot injection method as an example.

First, the first raw material is heated in advance. The heating rate is not particularly limited, but is heated at a heating rate of, for example, 1 to 30°C/min, typically 1 to 10°C/min.

The temperature of the first raw material after the heating is not particularly limited, but may be, for example, from room temperature to 450°C or from 120 to 360°C.

A second raw material is then added to the first raw material to react the complex having the first metal atom with the complex having the second metal atom. The second raw material may also be heated in advance in the same manner as the first raw material. The addition rate of the second raw material is not particularly limited, but is preferably adjusted in consideration of the temperature drop of the liquid phase due to the addition of the second raw material.

The liquid phase temperature after mixing is preferably from room temperature to 450°C, more preferably from 120 to 360°C, and still more preferably from 220 to 330°C.

For example, in case any of the complex having the first metal atom and the complex having the second metal atom has the ligand (dithiocarbamate ($S_2CNR_2$)) represented by the formula (1) described above, and if the temperature of the liquid phase is 120°C or higher, the reaction between the complex having the first metal atom and the complex having the second metal atom smoothly proceeds because of the metal complex having the ligand can be initiated the reaction by the amine-based compound. The reaction can be started without using an amine-based compound, but the temperature of the liquid phase is preferably higher than 120°C in this case.

In addition, when the temperature of the liquid phase is 360°C or less, vaporization of a commonly used solvent is suppressed, and stable liquid phase synthesis can be performed.

In the present embodiment, by adding the second raw material to the first raw material in a state in which the first raw material is preheated, the components contributing to the synthesis of the chalcogenide perovskite (solvents, complex having the first metal atom and complex having the second metal atom) are all brought to a high temperature at once in the liquid phase, so that the reaction initiation time point of the complex having the first metal atom and the reaction initiation time point of the complex having the second metal atom can be at approximately the same time. Therefore, the reaction of the complex having the first metal atom and the reaction of the complex having the second metal atom proceed in a well-balanced manner, and the chalcogenide perovskite can be synthesized with high purity.

In one embodiment, when the above-described amine-based compound is added to the liquid phase as an initiator, the raw material components contain solvents, the complex having the first metal atom, the complex having the second metal atom, and the amine-based compound. The combination of the component to be the first raw material and the component to be the second raw material is not particularly limited.

For example, the first raw material may be the solvent only, and the second raw material may be a mixture of the complex having the first metal atom, the complex having the second metal atom, and the amine-based compound.

Alternatively, the first raw material may be a mixture of the solvent and the amine-based compound, and the second raw material may be a mixture of the complex having the first metal atom and the complex having the second metal atom.

Alternatively, the first raw material may be a mixture of one of complex having a first metal atom and complex having a second metal atom and the solvent, and the second raw material may be a mixture of the other of complex having the first metal atom and complex having the second metal atom and the amine-based compound.

In one embodiment, when the chalcogen compound described above is added to the liquid phase, the raw material components contain solvents, the complex having the first metal atom, the complex having the second metal atom, and the chalcogen compound.

In this case, the combination of the component to be the first raw material and the component to be the second raw material is not particularly limited.

For example, the first raw material may be the solvent only, and the second raw material may be a mixture of the complex having the first metal atom, the complex having the second metal atom, and the chalcogen compound.

Alternatively, the first raw material may be a mixture of the solvent and the chalcogen compound, and the second raw material may be a mixture of the complex having the first metal atom and the complex having the second metal atom.

Alternatively, the first raw material may be a mixture of one of complex having the first metal atom and complex having the second metal atom and the solvent, and the second raw material may be a mixture of the other of complex having the first metal atom and the complex having the second metal atom and the chalcogen compound.

In one embodiment, the liquid phase obtained by adding the second raw material to the first raw material is heated and stirred at a temperature of preferably room temperature to 450°C, more preferably 120 to 360°C, and still more preferably 220 to 330°C, for example, 0 to 24 hours. After completion of the stirring, the precipitate precipitated in the liquid phase is isolated by a known method to obtain the chalcogenide perovskite as the target substance.

The reason why 120°C or higher is preferable and the reason why 360°C or lower is preferable is the same as that described in the example in the case of using the hot injection method.

In the above-described series of liquid phase synthesis, it is preferable to carry out the synthesis in a state in which components such as water and oxygen are removed as much as possible so that no components such as water and oxygen are present in the synthesis atmosphere. For example, the above-described series of liquid-phase synthesis is preferably performed under an inert atmosphere filled with nitrogen or argon.

The production method of the present aspect may be performed, for example, by the flow synthesis method described below.

First, the complex having the first metal atom, the complex having the second metal atom, and at least one of the chalcogen compound and the amine-based compound are dissolved in solvents, respectively, and are separately circulated as raw material flows of three lines or four lines.

The reaction is then initiated by merging all the raw material flows simultaneously or stepwise. At this time, it is preferable that at least one of the raw material flows is heated in advance before merging. The preheated feed flow is preferably the flow with the highest flow rate. In addition, since the flow synthesis has a small reaction field, the flow synthesis can be instantaneously heated even if it is heated immediately after the merging of the raw material flows, and the reaction start time of the complex having the first metal atom and the reaction start time of the complex having the second metal atom can be at approximately the same time. The heating rate at the time of heating and the temperature of the component after heating are the same as those of the hot injection method. The following steps are similar to the hot injection method.

According to the flow synthesis method, the components contributing to the synthesis of the chalcogenide perovskite can be heated in a short time after merging, so that the reaction initiation time of the complex having the first metal atom and the reaction initiation time of the complex having the second metal atom can be at approximately the same time. Further, since the flow synthesis has a small reaction field, the collision probability between the raw materials, that is, the reaction efficiency is high. Therefore, the reaction of the complex having the first metal atom and the reaction of the complex having the second metal atom proceed in a well-balanced manner, and the chalcogenide perovskite can be synthesized with high purity.

In addition, the yield of chalcogenide perovskite is increased, and the energy cost can be reduced. In addition, since the amount of waste of impurities contained in the final composite can be reduced, the environmental load can be reduced. In addition, since an accident such as an explosion on a production line caused by an impurity can be prevented, safety in producing can be enhanced.

According to the method for producing of the present aspect described above, it is possible to obtain chalcogenide perovskite particles without performing the firing step. In general, when the firing step is performed, the nano-sized primary particles are aggregated to form secondary particles, but when the firing step is not performed, the generation of such secondary particles is suppressed. Therefore, it is possible to obtain chalcogenide perovskite nanoparticles having a fine crystallite size.

Since the method for producing of the present aspect described above is based on the liquid-phase synthesis method, impurities are less likely to be mixed into the particles in the synthesis process than in the solid-phase synthesis method. In addition, since the liquid-phase synthesis method is characterized by uniform nucleation and particle growth from the liquid phase, fine nanoparticles with narrow particle size distribution can be obtained by preventing aggregation of nuclei generated in the liquid phase (see, for example, "Sumishi Kanie et al., "Liquid-phase synthesis of size-and morphology-controlled functional inorganic nanoparticles and their development into a hybrid material by surface-precise organic modification", Journal of the Japanese Association for Crystal Growth, 2017, Vol.44, No.2, p.66-73").

Therefore, according to the method for producing of the present aspect, it is possible to obtain chalcogenide perovskite nanoparticles having less contamination of impurities in the particles, narrow particle size distribution, uniform and fine crystallite size.

[Form of use]

Examples of the use form of the chalcogenide perovskite according to one aspect of the present invention include a powder, a thin film, and a sheet.

(Powder)

In the present specification, the powder of chalcogenide perovskite refers to a powder of chalcogenide perovskite conglomerated or aggregated.

The powder of chalcogenide perovskite may contain material other than chalcogenide perovskite as an additive in order to improve various properties such as luminescence properties, dispersibility in other material, and film-forming properties when used as a dispersion or other composition as described later.

In the following description, a polycrystal of chalcogenide perovskite (for example, a polycrystal indicated by reference numeral 20 in Figure 1) or a single crystal of chalcogenide perovskite may be referred to as a primary particle of chalcogenide perovskite.

In the following description, the primary particles of chalcogenide perovskite aggregated are sometimes referred to as secondary particles. That is, the powder of chalcogenide perovskite refers to a conglomerate of primary particles and/or secondary particles of chalcogenide perovskite, or a mixture of these and an additive.

In the present specification, when the primary particles of chalcogenide perovskite are single crystals, the size d20 of the primary particles corresponds to the size d10 of the crystallites. When the primary particles of the chalcogenide perovskite are polycrystals composed of crystallites having a diameter d10 (corresponding to the polycrystals 20 in Figure 1), the size d20 of the primary particles corresponds to the diameter of the polycrystals 20.

The size of the primary particles and the secondary particles of the chalcogenide perovskite contained in the powder is not particularly limited. The size of the primary particles is preferably, for example, 5 to 1000 nm, more preferably 5 to 100 nm, and still more preferably 5 to 20 nm.

The primary or secondary particles of the chalcogenide perovskite may be surface modified with a ligand.

The type of the ligand for modifying the surface of the primary particle or the secondary particle is not particularly limited, and examples thereof include at least one kind selected from the group consisting of oleylamine, oleic acid, dodecanethiol, and trioctylphosphine.

The use of powder of chalcogenide perovskite is not particularly limited. For example, the powder of chalcogenide perovskite may be dispersed in a liquid dispersion medium to be used as the state of the above-described dispersion liquid, or the powder of chalcogenide perovskite may be dispersed in a resin or a solid medium (solid dispersion medium) to be used as a composition.

The powder of chalcogenide perovskite may be sintered and used as a sintered body. The sintered body of the chalcogenide perovskite powder can be used, for example, as a sputtering target.

The powder of chalcogenide perovskite may be used as a powder. The chalcogenide perovskite powder can be used, for example, as a vapor deposition source when performing a vapor deposition process.

(Thin Film)

In the present specification, a thin film of chalcogenide perovskite refers to a film in which chalcogenide perovskite is aggregated in a planar manner.

The thin film of chalcogenide perovskite may contain material other than chalcogenide perovskite as an additive in order to improve various properties such as dispersibility and light emission properties of chalcogenide perovskite in the film.

The size of the primary particles and the secondary particles of the chalcogenide perovskite contained in the thin film of chalcogenide perovskite is not particularly limited. The size of the primary grains contained in the thin film is preferably, for example, 5 to 1000 nm, more preferably 5 to 100 nm, and still more preferably 5 to 20 nm.

The method for producing the thin film is not particularly limited.

For example, a thin film of chalcogenide perovskite may be formed using a dispersion liquid in which nanoparticles of chalcogenide perovskite are dispersed in a liquid dispersion medium, or a precursor material of chalcogenide perovskite (for example, a dispersion liquid in which the complex having the first metal atom and the complex having the second metal atom are dispersed in a dispersion medium), by a solution film forming method such as application process, spraying method, doctor blade method, ink-jet method, or the like, and then drying, firing, or the like as needed.

For example, as a film forming material, a precursor material (a dispersion liquid in which the complex having the first metal atom and the complex having the second metal atom are dispersed in a dispersion medium) is used, and when the film is formed by a solution film forming method such as application process, the coating film is heat-treated at a predetermined temperature, whereby the complex having the second metal atom and the complex having the first metal atom react in the coating film. Thus, a thin film containing chalcogenide perovskite according to one aspect of the invention is obtained.

The method of forming the thin film is not limited to the above-described film forming method, and for example, a thin film of chalcogenide perovskite may be formed by forming chalcogenide perovskite nanoparticles (for example, a powder containing nanoparticles, a molded body or a fired body of the powder, or the like) or a chalcogenide perovskite precursor material into film using a vacuum method such as a sputtering method or a vacuum deposition method, and then, if needed, firing or other treatment.

When the treatment such as heating and firing is performed, the chalcogenide perovskite in the finally obtained thin film does not necessarily have to maintain the particle shape before the heat treatment or the like is performed.

(Sheet)

In the present specification, a sheet of chalcogenide perovskite refers to a composition in which chalcogenide perovskite is dispersed in a solid dispersion medium and is formed in a planar shape.

The sheet of chalcogenide perovskite may contain silica fine particles, acids, bases, binder material, and the like other than the chalcogenide perovskite as an additive in order to improve various properties such as dispersibility and luminescence.

The size of the primary particles and the secondary particles of the chalcogenide perovskite contained in the sheet of chalcogenide perovskite is not particularly limited. The size of the primary particles contained in the sheet is preferable, for example, 5 to 1000 nm, more preferably 5 to 100 nm, and still more preferably 5 to 20 nm.

As the solid-state dispersing medium used for the sheet of chalcogenide perovskite, a known polymer material used for this type of object can be arbitrarily applied.

In one embodiment, a polymer material as a solid-state dispersing medium for use in a sheet of chalcogenide perovskite is preferably a polymer having a translucent or substantially transparent appearance when formed into a sheet.

The solid-state dispersing medium used for the sheet of chalcogenide perovskite is not particularly limited, and examples thereof include polyvinyl butyral, polyvinyl acetate, silicone, and a derivative of silicone.

Examples of the derivative of silicone include polyphenylmethylsiloxanes, polyphenylalkylsiloxanes, polydiphenylsiloxanes, polydialkylsiloxanes, fluorinated silicones, and vinyl and hydride-substituted silicones.

As the solid-state dispersion medium of the sheet, other than those described above, for example, ionomers, polyethylenes, polyvinyl chloride, polyvinylidene chloride, polyvinyl alcohol, polypropylene, polyester, polycarbonate, polystyrene, polyacrylonitrile, ethylene acetate vinyl copolymer, ethylene vinyl alcohol copolymer, ethylene methacrylic acid copolymer film, nylon, and the like may be used.

The method for producing the sheet is not particularly limited.

For example, a sheet of chalcogenide perovskite may be produced by kneading and stretching the above-described powder of chalcogenide perovskite and a solid-state dispersion medium.

Further, a dispersion liquid, which is a mixture of a liquid composition obtained by mixing chalcogenide perovskite and various additives and a precursor of a solid dispersion medium or a solid dispersion medium, may be produced by applying the mixture to a sheet and then drying or the like as necessary.

In the thin film and the sheet described above, the primary particles or the secondary particles of the chalcogenide perovskite contained therein may be surface-modified with a ligand.

The kind of the ligand is not particularly limited, but for example, the same ligand as that exemplified in the powder item of chalcogenide perovskite can be used.

[Application]

The application of the chalcogenide perovskite obtained by the method for producing of the present aspect is not particularly limited. The chalcogenide perovskite according to one aspect of the present invention is suitable, for example, as an emitting material, a wavelength-converting element, or a photoelectric converting element in an emitting device such as a display.

Applications of the chalcogenide perovskite according to one aspect of the present invention or the above-described powder, dispersion, thin film (film), and sheet using the same include, for example, application to down-conversion of ultraviolet light or blue light in various devices.

The chalcogenide perovskite according to one aspect of the present invention or the above-described powder, dispersion, thin film (film), and sheet using the same can be suitably used for manufacturing various devices such as an emitting device such as a LED or an organic EL, a display device containing an emitting device, an illumination device containing an emitting device, an image sensor, a photoelectric converting element, and a bioluminescent label.

These various devices may include, for example, a thin film (film) or sheet containing chalcogenide perovskite according to one aspect of the present invention.

Examples

Production Example 1

(Synthesis of Ba Diisobutyldithiocarbamate)

Barium hydroxide (5140 mg) was weighed into a 100 mL three-necked flask, sealed with pure water 50 mL, and stirred.

Diisobutylamine (10.39 mL) was then added to the three-necked flask and stirred for an additional 10 minutes, and then carbon disulfide (3.63 mL) was added and stirred for 3 hours. By stirring, it was confirmed that the white solid gradually precipitated.

The precipitated solids were collected by filtration, washed with hexane, and then dried in vacuo to obtain a synthesis product comprising Ba diisobutyldithiocarbamate. The yield was about 70%.

Production Example 2

(Synthesis of Zr Diisobutyldithiocarbamate)

Zirconium chloride (2913 mg) was weighed into a 200 mL three-necked flask, and THF 75 mL was added to seal the container, and the mixture was stirred for about 15 minutes.

Diisobutylamine (29.2 mL) was then added to the three-necked flask, stirred for 10 minutes, then carbon disulfide (10.2 mL) was further added and stirred for an additional 3 hours.

After stirring, the precipitated solid was filtered and the filtrate was collected and transferred to a separate container.

The solvent was then removed from the collected filtrate in a known manner and the resulting residue was dispersed in hexane to give a white suspension.

The white suspension was filtered and the resulting solids were washed with hexanes and then dried in vacuo to obtain a synthesis product comprising Zr diisobutyldithiocarbamate. The yield was about 80%.

Example 1

Ba diisobutyldithiocarbamate (527.94 mg) obtained in Production Example 1 and Zr diisobutyldithiocarbamate (908.76 mg) obtained in Production Example 2 were weighed into a 50 mL three-necked flask, and 1-octadecene (5 mL) was added and stirred.

Then, the three-necked flask was moved into the draft while the inner atmosphere was maintained in a $N_2$ atmosphere. After the temperature was increased to 310°C at a temperature increase rate of 5°C/min, the oleylamine (1600 mg) at room temperature was inject with a Luer-lock syringe.

Then, the solution in the three-necked flask was kept at 310°C and stirred for 3 hours, and then an excess of 1-butanol was charged into the flask and quenched.

The solution in the three-necked flask was then collected and centrifuged, and the collected solid was redispersed in hexane and filtered to obtain a synthesis product.

Example 2

A synthesis product was obtained in the same manner as in Example 1, except that inject content of oleylamine in the three-neck flask was changed from 1600 mg to 3200 mg.

Comparative Example 1

Synthesis was carried out in the same manner as in US 2019/0225883 A1 Example 1.

First, a mixture of metal precursors obtained by mixing barium acetate and zirconium acetate hydroxide at a ratio of 1:1 (molar ratio) and oleic acid were dissolved in 1-octadecene as a solvent in a 200 mL reactor, and heated at 90°C for 60 minutes in vacuo.

The blended amount of oleic acid was 10 moles per mole of the mixture of metal precursors.

Next, the atmosphere in the reaction vessel was replaced with nitrogen gas, and then the temperature in the reactor was increased to 330°C.

A solution (S/ODE) in which sulfur is dispersed in octadecene was then injected into the reaction vessel and the mixture was allowed to react for 30 minutes with the temperature in the reaction vessel held at 310°C.

The injection amount of sulfur was about 10 moles per mole of the mixtures of metal precursors.

Next, the temperature of the reaction solution in the reaction vessel was quenched to room temperature, acetone was added, and the mixture was centrifuged, and then the obtained precipitate was dispersed in toluene, and a synthesis product was recovered from the obtained dispersion.

[X-ray diffraction analysis]

X-ray diffraction analysis was performed on the synthesis products obtained in Example 1, Example 2, and Comparative Example 1 by the following method.

X-ray wavelength: 1.5418 Å (CuKα ray)
Measuring range :5 to 60 (deg)

Measurement method: 2 θ-θ method

Measurement sample: A sample holder made of glass with a depression was filled with sample powders of the synthesis product obtained in Example 1, Example 2, and Comparative Example 1, the surface of the sample powders was leveled using a glass plate, and then the measurement was performed.

The X-ray diffraction spectra obtained for Example 1 and Example 2 are shown in Figure 2.

In the X-ray diffraction spectra obtained for Example 1, Example 2, and Comparative Example 1, the spectrum position indicating the peak intensity from the highest peak intensity to the fifth highest peak intensity are shown in Table 1 (Example 1 and Example 2) and Table 2 (Comparative Example 1), respectively.

In addition, in Table 1, for $BaZrS_3$ synthesized by solid phase synthesis (GdFeOs orthorhombic perovskite; space group: Pnma), the peak position indicating the peak intensity from the highest peak intensity to the fifth highest peak intensity in the X-ray diffraction spectrum, which is confirmed from JCPDS card No.00-015-0327 and ICSD (Inorganic Crystal Structure Database) #23288, and the respective lattice plane indexes are also shown.

In Figure 2, the peak position of the X-ray diffraction pattern, which is identified from the data base JCPDS card No.00-015-0327 and ICSD (Inorganic Crystal Structure Database) #23288, is indicated by a straight line.

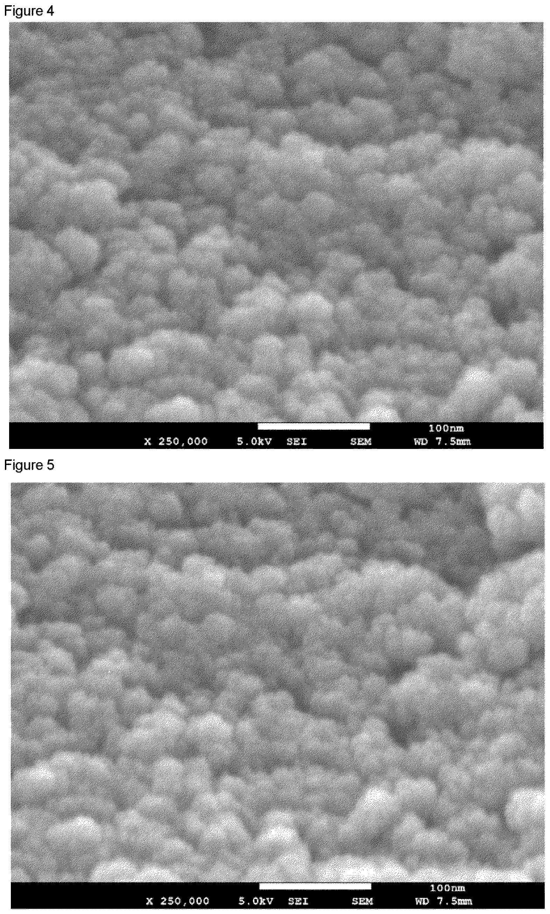

As a result of the X-ray diffraction described above, the peak of the X-ray diffraction spectrum obtained for Comparative Example 1 showed a peak substantially similar to the X-ray diffraction spectrum shown for Example 1 of US 2019/0225883 A1 (Figure 4).

Table 1

| Example 1 | Example 2 | Database | |
|---|---|---|---|
| peek position (deg) | peek position (deg) | peek position (deg) | plane indice (hkl) |
| 25.3762 | 25.4102 | 25.22 | (121) |
| 30.6448 | 30.5912 | 31.09 | (220) |
| 35.7674 | 35.7633 | 35.97 | (040) |
| 44.5767 | 44.7518 | 44.46 | (240) |
| 52.2352 | 52.2345 | 51.82 | (242) |

Table 2

| Comparative Example 1 |
|---|
| peek position (deg) |
| 5.7445 |
| 9.6597 |
| 12.5904 |
| 21.4423 |
| 23.5135 |

From Tables 1, the synthesis products obtained in Example 1 and Example 2 were confirmed that the peak position showing the top five peak intensities in the X-ray diffractometry spectrum almost agreed with $BaZrS_3$ (GdFeOs orthorhombic perovskite) synthesized by the solid phase synthesis based on JCPDS card. Considering measurement errors caused by measurement instruments, the deviation of the peak position within $\pm 1$ (deg) from the peak position based on JCPDS card is acceptable.

On the other hand, in the synthesis product obtained in Comparative Example 1, the peak position showing the top five peak intensities in the X-ray diffractometry spectrum was significantly different from $BaZrS_3$ synthesized by the solid-phase synthesis. That is, it is presumed that components other than $BaZrS_3$ are mixed in the synthesis product, or that JCPDS card-described structure $BaZrS_3$ cannot be synthesized as a main component.

[Particle size by Scherrer equation]

In the X-ray diffraction spectra obtained for Example 1 and Example 2 (see Figure 2), the crystallite size $\tau 1$ was calculated by a Scherrer equation represented by the following formula (a) based on the diffraction peak 1 having the largest peak height. The results are shown in Table 3. The half width $\beta$ was obtained by performing fitting by a split pseudo-Voigt function after removing the background by connecting both ends of the rise of the peak in the X-ray diffractometry spectrum shown in Figure 2 by a straight line.

$$\tau 1 = K\lambda/\beta\cos\theta \;...(a)$$

$\theta$: Diffraction angle of Maximum peak [rad]
$\beta$: Half width of Maximum peak [rad]
K: Shape factor
$\lambda$: X-ray wavelength
r1: crystallite size

Table 3

|  | Example 1 | Example 2 |
|---|---|---|
| K | 0.94 | 0.94 |
| $\lambda$ [Å] | 1.5418 (CuK$\alpha$ ray) | 1.5418 (CuK$\alpha$ ray) |
| diffraction angle $\theta$ of diffraction peek 1 [rad] | 0.2216 | 0.2216 |
| half width $\beta$ of diffraction peek 1 [rad] | 0.0134 | 0.0220 |
| crystallite size $\tau 1$ [nm] | 11.06 | 6.747 |

[Particle size by Williamson-Hall equation]

The crystallite size $\tau 2$ was calculated by Williamson-Hall equation (Williamson-Hall's equation) represented by the following formula (b) based on the diffraction peaks of the X-ray diffraction spectra (see Figure 2) obtained for Example 1 and Example 2. The half width $\beta$ was obtained by performing fitting by a split pseudo-Voigt function after removing the background by connecting both ends of the rise of the peak in the X-ray diffractometry spectrum shown in Figure 2 by a straight line.

$$\beta\cos\theta = \varepsilon(2\sin\theta) + K\lambda/\tau 2 \;...(b)$$

$\theta$: Diffraction angle of diffraction peak [rad]
$\beta$: Half width of diffracted peak [rad]
K: Shape factor
$\lambda$: X-ray wavelength
$\varepsilon$: lattice strain
$\tau 2$: crystallite size

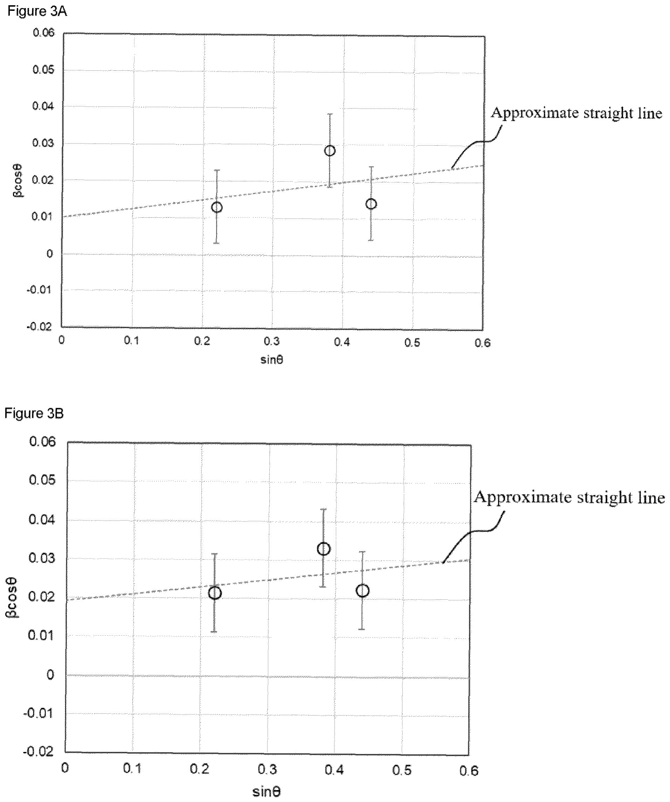

Specifically, in the crystallite size $\tau 2$, for each diffraction peak (peak 1: 25 deg (0.22 rad), peak 2: 45 deg (0.39 rad), peak 3: 52 deg (0.45 rad) observed in the X-ray diffraction spectrum shown in Figure 2, each diffraction angle $\theta$ and the half width $\beta$ (see Table 4) were substituted into the above formula (b), and each $\sin\theta$ was plotted as an x-axis and each $\beta\cos\theta$ was plotted as a y-axis to create an approximate straight line.
An approximate straight line (y=0.0248x+0.0101) generated by plotting peak 1, peak 2, and peak 3 of Example 1 is shown in Figure 3A. Further, the approximate straight line (y=0.0188x+0.0192) generated by plotting the peak 1, the peak 2, and the peak 3 of the Example 2 is shown in Figure 3B.

Table 4

| | Example 1 | | | Example 2 | | |
|---|---|---|---|---|---|---|
| | peek 1 | peek 2 | peek 3 | peek 1 | peek 2 | peek 3 |
| diffraction angle θ of diffraction peek [rad] | 0.2216 | 0.3904 | 0.4557 | 0.2216 | 0.3907 | 0.4550 |
| half width β of diffraction peek [rad] | 0.0134 | 0.0310 | 0.016 | 0.0220 | 0.0360 | 0.025 |
| K | 0.94 | | | 0.94 | | |
| λ [Å] | 1.5418 (CuKα ray) | | | 1.5418 (CuKα ray) | | |

Then, in the approximate straight line, the lattice strain ε was calculated from each slope (2ε) and the crystallite size $\tau2$ was calculated from the intercept ($K\lambda/\tau2$). The results are shown in Table 5.

Table 5

| | approximate straight line | |
|---|---|---|
| | Example 1 | Example 2 |
| lattice strain ε | 0.0124 | 0.0094 |
| crystallite size $\tau2$ [nm] | 14.32 | 7.547 |

The synthesis product obtained in Example 1 was observed using a scanning electrons microscope (produced by JEOL Ltd., "JSM-7610F") (hereinafter referred to as SEM observation) at 250000x magnification and 5kV acceleration-voltage in two arbitrarily selected locations.

Figure 4 and Figure 5 show images (hereinafter, referred to as SEM images) obtained by SEM observation of the synthesis product obtained in Example 1.

SEM images illustrated in Figure 4 and Figure 5 are images captured in such a manner that 260 or more grains are included in the captured image area. One of the two observed images is shown in Figure 4 and the other is shown in Figure 5.

In addition, the synthesis product obtained in Example 2 was observed using a scanning transmission electrons microscope (manufactured by JEOL Ltd., "JSM-7610F") (hereinafter referred to as STEM observation) at 200000x or 400000x magnification 5kV acceleration-voltage in two arbitrarily selected locations.

Specifically, one of the two arbitrarily selected locations in the synthesis product obtained in Example 2 was observed at 200000x magnification, and the other site was observed at 400000x magnification.

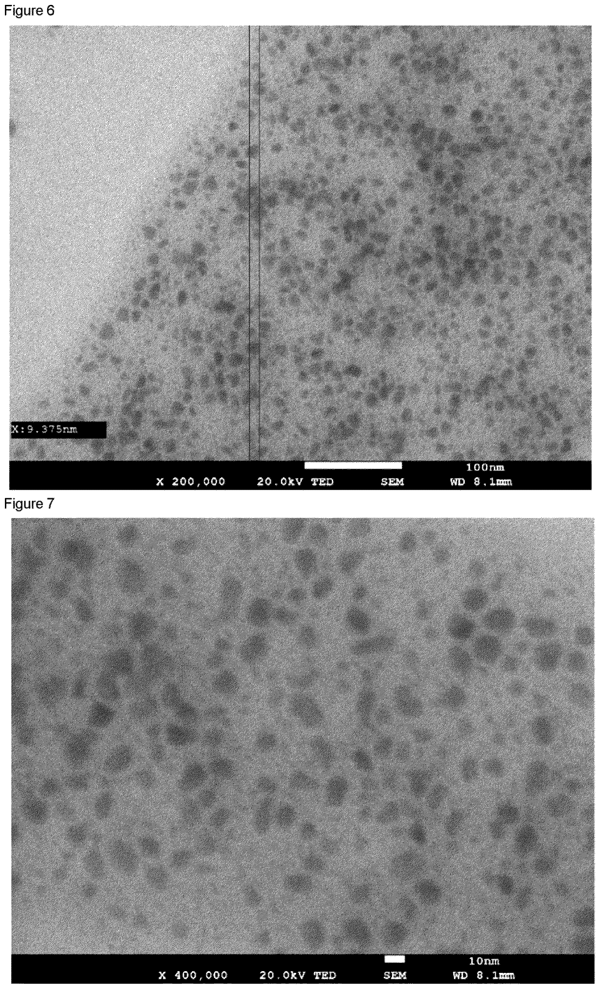

Images obtained by STEM observations by scanning transmission electron microscopy (hereinafter, referred to as STEM images) of the synthesis product obtained in Example 2 are shown in Figure 6 (200000x magnification) and Figure 7 (400000x magnification).

STEM image illustrated in Figure 6 is an image captured in such a manner that 200 or more grains are included in the captured image area. In addition, STEM images illustrated in Figure 7 are images captured in such a manner that 450 or more grains are included in the captured image area.

In the respective images shown in Figures 4 to 7, the Haywood diameter of the particles that can be confirmed in the image was measured, and among the particles to be measured, the particle $P_L$ having a Haywood diameter of 10 μm or more was specified.

The total area occupied by the particle $P_L$ present in the image range was calculated for each image, and the proportion to the total area occupied by the particles present in the image range was calculated by the following formula (α).

(Total area occupied by particle $P_L$ present in the image)/(Total area occupied by particles present in the image)×100

In SEM images shown in Figure 4, the value calculated by the formula (α) was 0%, and in SEM images shown in Figure 5, the value calculated by the formula (α) was 0%.

Similarly, in STEM images shown in Figure 6, the value calculated by the formula (α) was 0%, and in STEM images shown in Figure 7, the value calculated by the formula (α) was 0%.

In the respective SEM images illustrated in Figures 4 and 5, the widths indicated by white lines at the lower end correspond to 100 nm.

As can be seen from Figure 4 and Figure 5, no particles having a particle diameter (Haywood diameter) of more than 100 nm were confirmed in any of SEM images obtained by capturing the synthesis product of Example 1.

Similarly, in STEM image illustrated in Figure 6, the width indicated by a white line on the lower end side corresponds to 100 nm, and in STEM image illustrated in Figure 7, the width indicated by a white line on the lower end side corresponds to 10 nm.

As can be seen from Figure 6 and Figure 7, no particles having a particle diameter (Haywood diameter) more than 100 nm were confirmed in any of STEM images obtained by capturing the synthesis product of Example 2.

Industrial Applicability

The chalcogenide perovskite of the present invention can be applied to, for example, an emitting material, a wavelength-converting element, or a photoelectric converting element in an emitting device such as a display.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification and the specification of Japanese application(s) on the basis of which the present application claims Paris convention priority are incorporated herein by reference in its entirety.

**Claims**

1. A chalcogenide perovskite, having

   a crystallite size $\tau 1$ of less than 40 nm, calculated by Scherrer equation based on the diffraction peak having the largest peak height in the X-ray diffraction spectrum obtained by X-ray diffraction measurement, and
   a proportion of a total area occupied by particles having a particle diameter of 10 $\mu$m or more measured by microscopy to a total area occupied by particles existing in a captured image range in an image range captured by a microscope of 10% or less.

2. The chalcogenide perovskite according to claim 1, wherein a crystallite size $\tau 2$ calculated by Williamson-Hall equation based on an X-ray diffraction spectrum obtained by X-ray diffraction measurement is 34.5 nm or less.

3. The chalcogenide perovskite according to claim 2, wherein the crystallite size $\tau 2$ is 30 nm or less.

4. The chalcogenide perovskite according to any one of claims 1 to 3, wherein the crystallite size r1 is less than 17.5 nm.

5. The chalcogenide perovskite according to any one of claims 1 to 4, wherein the chalcogenide perovskite has a composition represented by the following formula (101) or (102):

   $$ABCh_3 \cdots \qquad (101)$$

   $$A'_2A_{n-1}B_nCh_{3n+1} \cdots \qquad (102)$$

   wherein in the formula (101), (102), A and A' are independently Sr, Ba or a combination thereof, B is Zr, Hf or a combination thereof, and Ch is S, Se, Te or a combination thereof; in the formula (102), n is an integer of 1 to 10; in the formula (102), A and A' may be the same as or different from each other; and the chalcogenide perovskite may be a solid solution obtained by substituting a part or all of A, A', B, and Ch with another element in the composition represented by the formula (101) or (102).

6. The chalcogenide perovskite according to any one of claims 1 to 5, wherein the particles of chalcogenide perovskite are surface-modified by a ligand.

7. A composition, wherein the chalcogenide perovskite according to any one of claims 1 to 6 is dispersed in a dispersion medium.

8. The composition according to claim 7, which is a dispersion liquid using a liquid dispersion medium as the dispersion medium.

9. The composition according to claim 8, wherein the liquid dispersion medium is at least one selected from the group consisting of water, ester, ketone, ether, alcohol, glycol ether, organic solvent having an amide group, organic solvent having a nitrile group, organic solvent having a carbonate group, organic solvent having a halogenate hydrocarbon group, organic solvent having a hydrocarbon group, and dimethyl sulfoxide.

10. The composition according to claim 7, which is a sheet using a solid-state dispersion medium as the dispersion medium.

11. The composition according to claim 10, wherein the solid-state liquid dispersion medium is at least one selected from the group consisting of polyvinyl butyral, polyvinyl acetate, and silicone and derivative thereof.

12. A powder comprising the chalcogenide perovskite according to any one of claims 1 to 6.

13. The powder according to claim 12, wherein primary particles or secondary particles of the chalcogenide perovskite are surface-modified with a ligand.

14. A sintered body obtained by sintering the powder according to claim 12 or 13.

15. A thin film comprising the chalcogenide perovskite according to any one of claims 1 to 6.

16. A method for producing the thin film according to claim 15, wherein the dispersion liquid according to claim 8 or 9 is deposited by an application method, a spraying method, a doctor blade method, or an ink-jet method.

17. A method for producing the thin film according to claim 15, wherein the chalcogenide perovskite powder according to claim 12 or 13 is deposited by a sputtering method or a vacuum deposition method.

18. A method for producing the sheet according to claim 10, wherein the dispersion liquid according to claim 8 or 9 is applied in a sheet form and then dried.

19. An emitting material comprising the chalcogenide perovskite according to any one of claims 1 to 6.

20. An emitting device, an image sensor, a photoelectric converter, or a bioluminescent label, comprising the chalcogenide perovskite according to any one of claims 1 to 6.

21. A method for producing a chalcogenide perovskite, wherein a complex having a first metal atom and a complex having a second metal atom are reacted in a liquid phase, wherein the complex having a first metal atom and the complex having a second metal atom has a ligand free of oxygen atom (O) and halogen atom (X) as coordination atoms.

22. The method for producing according to claim 21, wherein the complex having a first metal atom and the complex having a second metal atom independently have a ligand coordinating with atom selected from the group consisting of nitrogen atom (N), sulfur atom (S), selenium atom (Se), tellurium atom (Te), carbon atom (C), and phosphorus atom (P).

23. The method for producing according to claim 21 or 22, wherein the metal atom of the complex having a first metal atom is at least one of Sr and Ba, and the metal atom of the complex having a second metal atom is at least one of Zr and Hf.

24. The method for producing according to claim 23, wherein at least one selected from Ti, Ca, and Mg is further used for at least one of the metal atom of the complex having a first metal atom and the metal atom of the complex having a second metal atom.

25. The method for producing according to any one of claims 21 to 24, wherein the ligand is a dithiocarbamate, a xanthate, a trithiocarbamate, a dithioester, a thiolate, a sulfide, a compound substituted a part or all of sulfur atom contained therein with a selenium atom or a tellurium atom, an alkylamine, an arylamine, a trialkylsilylamine, a nitrogen-containing aromatic ring, an alkane, an unsaturated hydrocarbon ring, the group derived from the unsaturated hydrocarbon ring, a cyan, a trialkylphosphine, a triarylphosphine, or a diphosphine.

26. The method for producing according to any one of claims 21 to 25, wherein the complex having a first metal atom and the complex having a second metal atom is a binuclear complex of a single compound.

27. The method for producing according to claim 26, wherein the first metal atom and the second metal atom are bonded via a ligand coordinating with sulfur atom, selenium atom, or tellurium atom.

28. The method for producing according to any one of claims 21 to 27, wherein the chalcogenide perovskite has a composition represented by the following formula (101) or (102):

$$ABCh_3 \cdots \qquad (101)$$

$$A'_2A_{n-1}B_nCh_{3n+1} \cdots \qquad (102)$$

wherein in the formula (101), (102), A and A' are independently Sr, Ba or a combination thereof, B is Zr, Hf or a combination thereof, and Ch is S, Se, Te or a combination thereof; in the formula (102), n is an integer of 1 to 10; in the formula (102), A and A' may be the same as or different from each other; the chalcogenide perovskite may be a solid solution obtained by substituting a part or all of A, A', B, and Ch with another element in the composition represented by the formula (101) or (102).

29. The method for producing according to any one of claims 21 to 28, wherein a chalcogen compound is further added.

30. The method for producing according to any one of claims 21 to 29, wherein an amine-based compound is further added.

31. The method for producing according to any one of claims 21 to 30, wherein the temperature of the liquid phase is set at room temperature to 450°C.

32. The method for producing according to claim 31, wherein the temperature of the liquid phase is set at 120°C to 360°C.

33. The method for producing according to any one of claims 21 to 32, wherein the reaction is caused by adding a second raw material to a first raw material, and
the first raw material comprises at least a solvent among raw material components including the complex having a first metal atom, the complex having a second metal atom, and a solvent, and the second raw material comprises at least a raw material component not comprised in the first raw material among the raw material components.

34. The method for producing according to claim 33, wherein the reaction is caused by adding the second raw material to the first raw material in a state in which at least one of the first raw material and the second raw material is preheated.

35. The method for producing according to claim 33, wherein the reaction is caused by heating the first raw material and the second raw material after adding the second raw material to the first raw material.

36. The method for producing according to claim 35, wherein a dispersion liquid in which the complex having a first metal atom and the complex having a second metal atom are dispersed in a dispersion medium is deposited by an application method, spraying method, doctor blade method, or ink-jet method, and the obtained coating film is heat-treated.

37. The method for producing according to any one of claims 21 to 32, wherein the reaction is caused by simultaneously mixing the complex having a first metal atom, the complex having a second metal atom, and at least one of the chalcogen compound and the amine-based compound.

38. The method for producing according to claim 37, wherein the reaction is caused by circulating the complex having a first metal atom, the complex having a second metal atom, and at least one of the chalcogen compound and the amine-based compound as independent flows, and simultaneously merging the flows.

39. The method for producing according to claim 37 or 38, wherein at least one of the complex having a first metal atom, the complex having a second metal atom, and at least one of the chalcogen compound and the amine-based compound is preheated.

Figure 1

Figure 2

Figure 3A

Figure 3B

Figure 4

Figure 5

Figure 6

Figure 7

<table>
<tr><td colspan="2"><b>INTERNATIONAL SEARCH REPORT</b></td><td>International application No.<br><br><b>PCT/JP2022/044107</b></td></tr>
</table>

**A.     CLASSIFICATION OF SUBJECT MATTER**

*C01G 25/00*(2006.01)i; *B82Y 20/00*(2011.01)i; *B82Y 40/00*(2011.01)i
FI:    C01G25/00; B82Y40/00; B82Y20/00

According to International Patent Classification (IPC) or to both national classification and IPC

**B.     FIELDS SEARCHED**

Minimum documentation searched (classification system followed by classification symbols)

C01G25/00; B82Y20/00; B82Y40/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN); JSTPlus/JMEDPlus/JST7580/JSTChina (JDreamIII)

**C.     DOCUMENTS CONSIDERED TO BE RELEVANT**

| Category* | Citation of document, with indication, where appropriate, of the relevant passages | Relevant to claim No. |
|---|---|---|
| X | US 2019/0225883 A1 (SAMSUNG ELECTRONICS CO., LTD.) 25 July 2019 (2019-07-25)<br>    paragraphs [0005]-[0053], [0119]-[0122], examples 1-3 | 1-20 |
| X | INGRAM, Nicole E. et al. Dalton Transactions. 01 October 2021, vol. 50, pp. 15978-15982, DOI:10.1039/d1dt03018c<br>    fig. 1(d), 2D, p. 15979, right column, lines 35-41, p. 15980, right column, line 20 to p. 15981, right column, line 4, p. 15981, right column, lines 46-51 | 1-39 |
| A | CN 112978795 A (SHAOXING UNIVERSITY) 18 June 2021 (2021-06-18)<br>    paragraphs [0017]-[0034], examples 1-4 | 1-39 |
| A | PERERA, Samanthe et al. Nano Energy. 2016, vol. 22, pp. 129-135, DOI:10.1016/j.nanoen.2016.02.020<br>    abstract, "Synthesis of BaZrS3", "Results and discussions" | 1-39 |
| A | JP 2019-26542 A (MITSUBISHI CHEM CORP) 21 February 2019 (2019-02-21)<br>    claims 4-5 | 1-39 |

✓ Further documents are listed in the continuation of Box C.          ✓ See patent family annex.

| | |
|---|---|
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **07 February 2023** | **21 February 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2022/044107**

**C.    DOCUMENTS CONSIDERED TO BE RELEVANT**

| Category* | Citation of document, with indication, where appropriate, of the relevant passages | Relevant to claim No. |
|---|---|---|
| P, X | YANG, Ruiquan et al. Journal of the American Chemical Society. 24 August 2022, vol. 144, pp. 15928-15931, DOI:10.1021/jacs.2c06168<br>abstract, p. 15928, right column to p. 15930, right column | 1-39 |

Form PCT/ISA/210 (second sheet) (January 2015)

## INTERNATIONAL SEARCH REPORT

International application No.

**PCT/JP2022/044107**

---

**Box No. III        Observations where unity of invention is lacking (Continuation of item 3 of first sheet)**

---

This International Searching Authority found multiple inventions in this international application, as follows:

The claims are classified into the following two inventions.

(Invention 1)
Claims 1-20 share the common technical feature of a "chalcogenide perovskite" in which the "crystallite size $\tau 1$" and the "proportion of the total area occupied by particles having a particle diameter of at least 10 $\mu$m as measured by a microscopic method" are within predetermined numerical ranges, and are thus classified as invention 1.

(Invention 2)
Claim 21 does not share a common technical feature with invention 1 except for being a "chalcogenide perovskite". Therefore, claim 21 and claims 22-39 referring to claim 21 are classified as invention 2.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (January 2015)

**INTERNATIONAL SEARCH REPORT**
Information on patent family members

International application No.

**PCT/JP2022/044107**

| Patent document cited in search report | Publication date (day/month/year) | Patent family member(s) | Publication date (day/month/year) |
|---|---|---|---|
| US 2019/0225883 A1 | 25 July 2019 | CN 110065931 A<br>EP 3514215 A1<br>KR 10-2019-0089779 A | |
| CN 112978795 A | 18 June 2021 | (Family: none) | |
| JP 2019-26542 A | 21 February 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190225883 A1

**Non-patent literature cited in the description**

- **V. K. RAVI et al.** Colloidal BaZrS3 chalcogenide perovskite nanocrystals for thin film device fabrication. *The Royal Society of Chemistry, Nanoscale,* 2021, vol. 13, 1616-1623
- **S. FILIPPONE et al.** High densification of BaZrS3 powder inspired by the cold-sintering process. *Journal of Materials Research,* 2021, vol. 36, 4404-4412

- **SUMISHI KANIE et al.** Liquid-phase synthesis of size-and morphology-controlled functional inorganic nanoparticles and their development into a hybrid material by surface-precise organic modification. *Journal of the Japanese Association for Crystal Growth,* 2017, vol. 44 (2), 66-73